(19) Europäisches Patentamt / European Patent Office / Office européen des brevets

(11) **EP 3 519 089 B1**

(12) **EUROPEAN PATENT SPECIFICATION**

(45) Date of publication and mention
of the grant of the patent:
**15.11.2023   Bulletin 2023/46**

(21) Application number: **17797238.7**

(22) Date of filing: **02.10.2017**

(51) International Patent Classification (IPC):
**C23C 16/455** *(2006.01)*   **B01J 21/06** *(2006.01)*
**B01J 35/00** *(2006.01)*   **C03C 17/25** *(2006.01)*
**B01J 35/10** *(2006.01)*   **B01J 37/08** *(2006.01)*
**B01J 37/02** *(2006.01)*   **C23C 16/56** *(2006.01)*
**C23C 16/40** *(2006.01)*

(52) Cooperative Patent Classification (CPC):
**C23C 16/405; B01J 21/063; B01J 35/004;
B01J 35/1061; B01J 37/0215; B01J 37/082;
C03C 17/256; C23C 16/45525; C23C 16/45555;
C23C 16/56;** B01J 35/002; C02F 2305/10;
C03C 2217/212; C03C 2217/71; Y02W 10/37

(86) International application number:
**PCT/EP2017/074970**

(87) International publication number:
**WO 2018/060520 (05.04.2018 Gazette 2018/14)**

(54) **MESOPOROUS HYDROGENATED TITANIUM DIOXIDE**

MESOPORÖSES HYDRIERTES TITANDIOXID

DIOXYDE DE TITANE HYDROGÉNÉ MÉSOPOREUX

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority:  **30.09.2016  LU 93243**

(43) Date of publication of application:
**07.08.2019   Bulletin 2019/32**

(73) Proprietor: **Luxembourg Institute of Science and
Technology
4362 Esch-sur-Alzette (LU)**

(72) Inventors:
• **ISHCHENKO, Olga
2432 Luxembourg (LU)**
• **LENOBLE, Damien
6920 Wellin (BE)**

(74) Representative: **Lecomte & Partners
76-78, rue de Merl
2146 Luxembourg (LU)**

(56) References cited:
**WO-A1-03/092886     CN-A- 103 611 518
US-B2- 8 324 008**

• **PHEAMHOM RODJANA ET AL: "Characteristics
of atomic layer deposited TiO2 films and their
photocatalytic activity", JOURNAL OF VACUUM
SCIENCE AND TECHNOLOGY: PART A, AVS / AIP,
MELVILLE, NY., US, vol. 24, no. 4, 23 June 2006
(2006-06-23), pages 1535-1539, XP012091117,
ISSN: 0734-2101, DOI: 10.1116/1.2172941**
• **LEVCHUK IRINA ET AL: "Photocatalytic activity
of TiO2films immobilized on aluminum foam by
atomic layer deposition technique", JOURNAL
OF PHOTOCHEMISTRY AND PHOTOBIOLOGY,
A: CHEMISTRY, ELSEVIER SEQUOIA,
LAUSANNE, CH, vol. 328, 14 April 2016
(2016-04-14), pages 16-23, XP029641696, ISSN:
1010-6030, DOI:
10.1016/J.JPHOTOCHEM.2016.03.034**

- **KILPI LAURI ET AL: "Microscratch testing method for systematic evaluation of the adhesion of atomic layer deposited thin films on silicon", JOURNAL OF VACUUM SCIENCE AND TECHNOLOGY: PART A, AVS /AIP, MELVILLE, NY., US, vol. 34, no. 1, 1 January 1901 (1901-01-01), XP012202727, ISSN: 0734-2101, DOI: 10.1116/1.4935959 [retrieved on 1901-01-01]**

**Description**

**Technical field**

The invention is directed to a process involving atomic layer deposition in order to deposit mesoporous hydrogenated $TiO_2$ and to the resulting photocatalyst, additionally to its use in photocatalytic applications.

**Background art**

It is known that the major problem of $TiO_2$ ALD synthesis from $TiCl_4$ and water is the important roughness of the crystalline films (see Cheng H.-E., et al., Morphological and Photoelectrochemical properties of ALD TiO2 films, J. Electrochem. Soc., 2008, 155 (9), D604). Therefore it is mandatory to optimize the process growth in order to get the best trade-off between the film quality (that would trigger the photocatalytic properties) and its roughness that needs to be compatible with a 40 nm pore diameter.

Earlier research on $TiO_2$ ALD deposition from $TiCl_4$ and $H_2O$ determined typical deposition temperatures in a range of 200°C - 400°C (see Aarik J. et al., Morphology and structure of TiO2 thin film grown by ALD, J. Cryst. Growth., 1995, 148(3), 268-275). However, the high reactivity of the precursor also enables film formation at lower temperature (see Tan L. K., et al., Free-Standing Porous Anodic Alumina Templates for ALD of Highly Ordered TiO2 Nanotube Arrays an Various Substrate, 2008, 112(1), 69-73).

However, when porous substrates are used, deposition at low temperature is known to cause an inhomogeneous deposition into the porous space, leading to rough surface. This is a problem when further coating must be performed, for example for providing particular surface properties to substrate presenting a complexed surface.

Photocatalysis is a surface-dependant approach. Therefore, it is obvious that the increase of specific surface area would increase the photocatalytic activity. Thus, two kinds of nanoscale photocatalysts can be distinguished: suspensions of nanostructures in solutions or nanomaterials supported on appropriated templates. The main advantages of dispersed nanostructures are the simplicity of use and their low cost. Nevertheless, nanomaterials dispersed in solution tend to agglomerate, lowering their exposed specific surface area. Moreover, due to the toxicity of the nano-objects, they have to be removed after the pollutants degradation cycle, thus an additional filtration step is needed. For this reason, there is a growing interest in supported nanomaterials. To increase the exposed specific surface area of nano-textured photocatalysts, their synthesis at the surface of porous supports like membranes has been envisioned for water treatment (see Mozia S., Photocatalytic membrane reactors (PMRs) in water and wastewater treatment, Sep. Purif. Technol., 2010, 73(2), 71-91) or water splitting (see Tsydenov D.E. et al., Toward the design of asymmetric photocatalytic membranes for H2 production: preparation of TiO2-based membranes and their properties, Int. J. Hydrogen Energy, 2012, 37(15), 11046-11060).

The conventional photocatalytic approach, which uses basic metal oxides such as $TiO_2$, ZnO, $SnO_2$, is far from reaching the required efficiency. Light absorption limited to the UV range and fast recombination of photogenerated carriers are the main bottlenecks.

Various solutions were proposed to overcome these limitations. The direct band gap engineering via doping intends to lower the band gap energy by creation of additional energy levels. It will extend the light absorption in the visible range. The assembly of metal-oxides with plasmonic nanoparticles also allows the activation of conventional photocatalysts in the visible range. Moreover, this approach improves the photocatalytic activity in the UV range by electrons trapping. The semiconductor/semiconductor heterostructures approach acts on the carrier separation. The light management approach is already applied in the field of photovoltaics; it would be also interesting for the photocatalytic applications as a way of light absorption improvement. The periodic organisation of metal oxide nanostructures with a high refractive index offers myriad possibilities of light manipulation.

Nevertheless, the methods allowing the metal oxide structuration in the periodic arrays at deep sub-wavelength scale are expensive, especially for $TiO_2$ and $SnO_2$.

Therefore, it is an open challenge to develop large-scale and low-cost methods of periodic doped metal-oxides nanostructures over highly reflective substrate and to combine them with well- and periodically organised plasmonic nanoparticles.

CN 103 611 518 A relates to a preparation method of a sequential black mesoporous titanium dioxide visible light catalyst film. The preparation method is implemented by the following steps: 1, soaking: soaking a porous ceramic film into titanium dioxide sol; 2, drying: drying at the temperature of 60 to 90°C for 12 to 24 hours to obtain a porous ceramic film of the titanium dioxide sol; 3, performing heat treatment: maintaining the temperature of 400 to 800°C for 2 to 8 hours to obtain the porous ceramic film of the titanium dioxide sol after heat treatment; and 4, hydrogenating: hydrogenating for 2 to 10 hours under the condition of protective gas to obtain the sequential black mesoporous titanium dioxide visible light catalyst film.

WO 03/092886 A1 discloses a method for preparing mesoporous $TiO_2$ thin films with high antibacterial and photocatalytic activities. The method involves coating onto a substrate a TiO$_2$ sol-gel prepared from hydrolysis and condensation of titanium alkoxide in the presence of a stabilizer and thermally treating the substrate at a temperature ranging from 400°C to 900°C. Further relevant prior art is disclosed in: PHEAMHOM RODJANA ET AL: "Characteristics of atomic layer deposited TiO2 films and their photocatalytic activity",JOURNAL OF VACUUM SCIENCE AND TECHNOLOGY: PART A, AVS /AIP, MELVILLE, NY., US, vol. 24, no. 4, 23 June 2006 (2006-06-23), pages 1535-1539, XP012091117,ISSN: 0734-2101, DOI: 10.1116/1.2172941.

**Summary of invention**

Technical Problem

The invention has for technical problem to alleviate at least one of the drawbacks present in the prior art. More particularly, the invention has for technical problem to provide a simple process for considerably enhancing the photo-catalytic properties of TiO$_2$.

Technical solution

The invention is as defined in the independent claims. The first object of the invention is directed to a process for depositing TiO$_2$ on a substrate, comprising the steps of (a) providing a substrate, (b) performing said deposition with TiCl$_4$ and water by atomic layer deposition on said substrate; and (c) performing an annealing step. Said process is remarkable in that said step (b) is carried out at a temperature inferior to 50°C, and said step (c) is carried out at a temperature comprised between 450°C and 600°C in ambient air.
According to a preferred embodiment, said step (b) is carried out at a temperature comprised between 20°C and 50°C.
According to a preferred embodiment, said substrate is curved glass.
According to a preferred embodiment, said substrate is porous.
According to a preferred embodiment, said substrate is a silicon substrate with a layer of silicon oxide.
According to a preferred embodiment, said step (b) comprises pulsing TiCl$_4$ on said substrate so as to form a functionalized substrate, purging with an inert gas, pulsing H$_2$O on said functionalized substrate, and purging with an inert gas, said inert gas being preferentially nitrogen gas.
According to a preferred embodiment, said purging with an inert gas lasts between 5 seconds and 30 seconds.
According to a preferred embodiment, step (c) is carried out for at least 2 hours.
According to a preferred embodiment, step (b) is performed between 100 times and 1000 times.
The second object of the invention is directed to a photocatalyst comprising at least one layer of mesoporous hydrogenated TiO$_2$ on a substrate and obtainable by the process in accordance with the first object of the invention.
According to the invention, said at least one layer of mesoporous hydrogenated TiO$_2$ has a thickness which is comprised between 30 nm and 170 nm and is presenting a roughness, RMS value, as measured by AFM, of 0.77 nm at room temperature.
The third object of the invention is directed to an use of a photocatalyst as defined in accordance with the second object of the invention in a photocatalytic reaction performed under light irradiation, said light having a wavelength comprised between 1 nm and 780 nm.
According to a preferred embodiment, said photocatalytic reaction is a photocatalytic reaction of chemical degradation of acidic compound, neutral compound and/or basic compound.
According to a preferred embodiment, said photocatalytic reaction is a photocatalytic reaction of chemical degradation of methylene blue.
According to a preferred embodiment, said photocatalytic reaction is a photocatalytic reaction of chemical degradation of a mixture of methylene blue, rhodamine B and/or salicylic acid.
According to a preferred embodiment, said photocatalytic reaction is a photocatalytic reaction performed in water, wastewater, see water, river water, and/or industrial water.
According to a preferred embodiment, said photocatalytic reaction is a photocatalytic reaction performed in a water splitting process, a photolysis process and/or a hydrogen generation process.
In general, the particular embodiments of each object of the invention are also applicable to other objects of the invention. To the extent possible, each object of the invention is combinable with other objects.

Advantages of the invention

The invention is particularly interesting in that it provides a way to obtain a photocatalyst of titanium oxide that can act under the action of UV-visible light (light with a wavelength comprised between 1 nm and 780 nm) to perform efficient chemical degradation of organic compound, acidic, basic or neutral. Such photocatalyst is also very stable to the reaction conditions and can be reused multiple times.

**Brief description of the drawings**

Figure 1: Optical (SEM) images of $TiO_2$ films deposited in temperature range of RT-400°C.

Figure 2: X-Ray Diffraction (XRD) $TiO_2$ anatase (101) peak evolution as a function growth of temperature (200°C-400°C).

Figure 3: Diffractogram of the $TiO_2$ film synthesized at 400°C.

Figure 4: Growth rate of ALD $TiO_2$ films deposited at RT-400°C.

Figure 5: Possible paths of $TiCl_4$ chemisorption on oxide surfaces.

Figure 6: QCM as a function of deposition time recorded profile at 200°C using purge time of 2 s, 5 s, 30 s and 600 s for both precursors.

Figure 7: QCM as a function of deposition time as a recorded profile at 100°C using purge time of 600 s for both precursors.

Figure 8: QCM as a function of deposition time as a recorded profile at 20°C using purge time of 1800 s for both precursors.

Figure 9: QCM as a function of deposition time as a recorded profile at 20°C using purge time of 5s and 30s for both precursors.

Figure 10: XRD of $TiO_2$ deposited at 200°C after annealing at 600°C.

Figure 11: Photocatalytic degradation of methylene blue solution on the room temperature-deposited $TiO_2$ films under visible light.

Figure 12: Photocatalytic degradation constant normalized by the sample surface area as the function of the film thickness for both purge time regimes, namely 5 s and 30 s.

Figure 13: XPS O 1s spectra of amorphous and annealed $TiO_2$ film obtained by room temperature ALD.

Figure 14: Comparison plot of the absorption coefficient (left axis) and photoluminescence spectra (right axis).

Figure 15: Optical (SEM) images of room temperature $TiO_2$ film deposited after 965 cycles in short purge time regime (top view and tilted images).

Figure 16: Repeatability of the methylene blue photocatalytic degradation in the UV range repeated four times.

Figure 17: Photocatalytic degradation of methylene blue, rhodamine B and salicylic acid on room temperature $TiO_2$ films in the UV and visible ranges.

**Description of the disclosure**

Thin films of ~25-40 nm are obtained using standard conditions provided by the ALD equipment supplier: precursors pulse 0.2 s and purge time 2 s for both precursors (for temperature range 200-400°C).

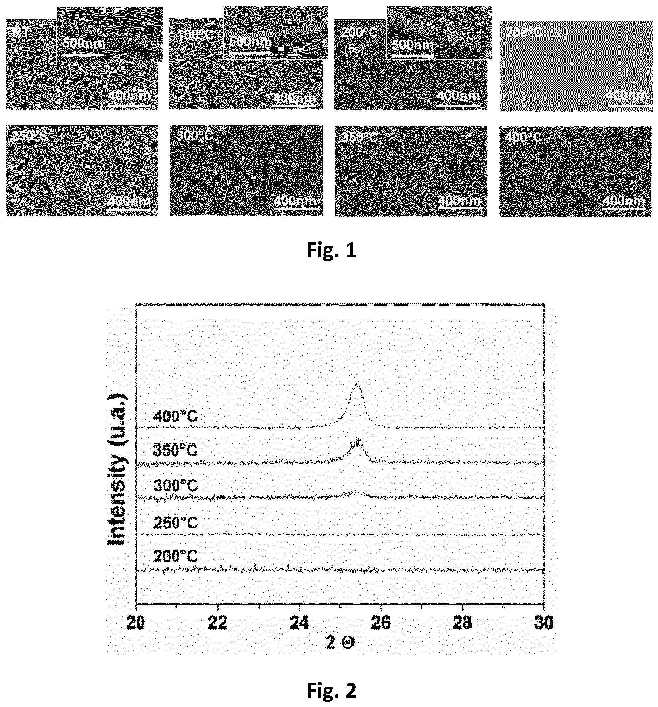

In the low temperature range (20°C (RT) -200°C) depositions of thicker films (~100 nm) are obtained with longer purge time as 5 s and 30 s. The SEM and AFM measurement (see figure 1 and table 1) show that the roughness of films increases with the deposition temperature.

Table 1: Summary on the thickness and roughness of $TiO_2$ films (as deposited)

| Growth temperature (°C) | Roughness, RMS, nm (from AFM) |
|---|---|
| RT | 0.77 |
| 100 | 0.68 |
| 200 (purge 5s) | 0.75 |
| 200 (purge 2s) | 1.70 |
| 250 | 3.13 |
| 300 | 7.64 |
| 350 | 16.98 |
| 400 | 5.64 |

Samples grown in the low temperature range (RT-200°C) show a smooth and highly conformal films, while films obtained at 350°C show the highest RMS value (16.98 nm).

It is worth noting that the roughness decreases suddenly for the films deposited at 400°C. These results until 350°C are in agreement with the literature (see Huang. Y, et al., Characterization of low temperature deposited ALD TiO2 for MEMS application, J. Vac. Sci. Technol. A Vacuum, Surfaces, Films, 2012, 31, 01A148). Therefore, from the morphological point of view, for further deposition into porous substrate, the low temperature range (RT-200°C) is privileged.

However, for better understanding of the morphology variation, the growth mechanisms have to be discussed. The formation of random nanoparticles for the deposition at 200°C and purge time 2 s has been observed, similarly reported by Luka et al. (Kinetics of anatase phase formation in TiO2 films during ALD and post-deposition annealing, CrystEngComm., 2013, 15(46), 9949). Such nanoparticles formation may unfortunately cause an inhomogeneous deposition into the porous space. The increase of the purge time to 5 and 30 s has solved this problem.

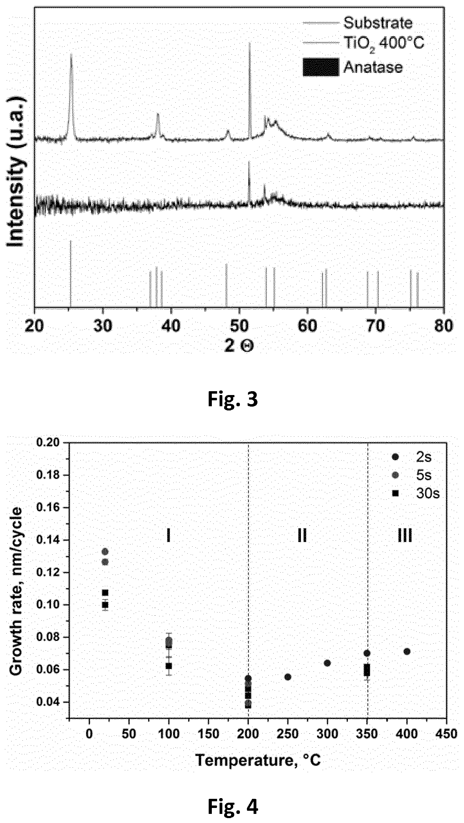

The XRD analysis demonstrates that films synthesised at a temperature below 300°C do not show any crystalline structure, therefore diffractograms for films deposited at RT and 100°C are not presented (see figure 2). The anatase crystalline phase is detected for the depositions beyond 300°C and the increase of deposition temperature up to 400°C logically improves the film crystallinity (see figure 3).

The growth rate (growth per cycle, GPC) in whole temperature range (RT-400°C) represented on figure 4 for $TiO_2$ films.

Three growth regimes can be distinguished: (i) low temperature regime (RT-200°C) where the growth rate decreases with the temperature increase that corresponds to the ALD condensation regime; (ii) intermediate regime (200°C-350°C) demonstrate a growth rate increase followed by the standard ALD plateau (iii) at high temperature regime (>350°C).

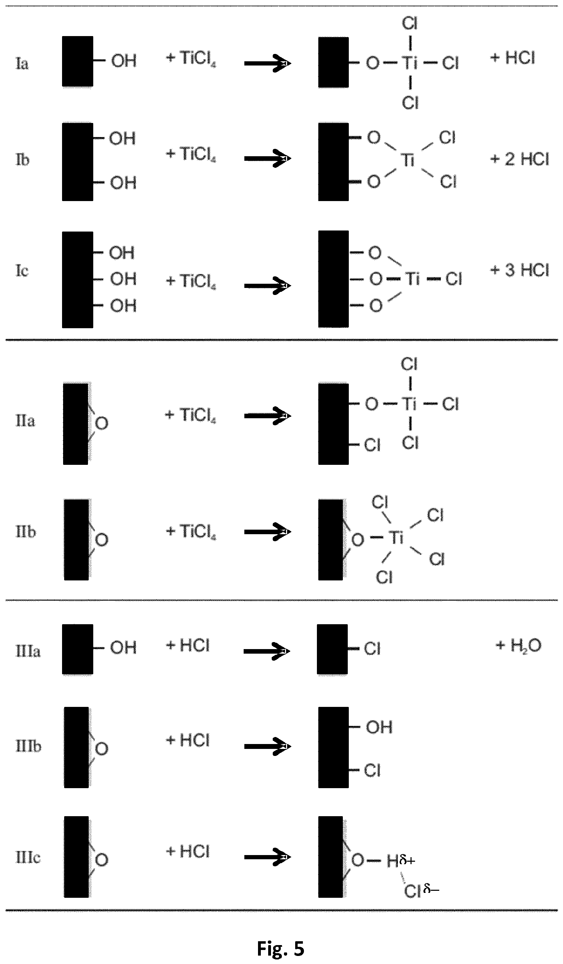

It is generally established that the surface reaction with the metal-oxide precursor mainly involves the OH functional groups (see Aarik J. et al., ALD of TiO2 from TiCl4 and H2O: investigation of growth mechanism, Appl. Surf. Sci., 2001, 172, 148-158). Therefore, the typical $TiO_2$ growth reaction follows equations 1 and 2 and is schematically represented on Figure 5.

$$[\text{Pulse TiCl}_4]: \quad x(-OH)_x + TiCl_4 \rightarrow (-O-)_x TiCl_{4-x} + xHCl \ (x=1, 2)$$

$$(\text{equation 1})$$

$$[\text{Pulse H}_2O]: \quad (-O-)_x TiCl_{4-x} + (4 - x)H_2O \rightarrow (-O-)_x Ti(OH)_{4-x} + (4-x)HCl$$

$$(\text{equation 2})$$

Nevertheless, the surface chemistry is highly dependent on the temperature. At low temperatures (<300°C), the isolated hydroxyl groups OH and H-bonded OH groups are dominate on the surface of substrates such as $SiO_2$ or $Al_2O_3$. The increase of temperature (>300°C) may lead to the dehydroxilation and the formation of oxygen bridges (equation 3).

$$Ti(-OH)-O-Ti(OH) \rightarrow Ti(-O-)_2 Ti + H_2O$$

$$(\text{equation 3})$$

At high temperature, the oxygen bridge terminated surface promotes also the direct $TiCl_4$ chemisorption according to IIa-IIb reaction paths showed on figure 5 and used to improve the film quality because of the lack of HCl by-product.

The GPC increase in the intermediate regime can be related to the temperature dependent surface functionalities and also the important role of the HCl by-product on the growth mechanisms.

In the literature, the role of HCl on the $TiO_2$ growth mechanism was fully established by Leem et al., Role of HCl in ALD of TiO2 thin films from TiCl4 and water, 2014, 35(4), 1195-1201). The authors showed that in the temperature range 150-300°C, the volontary addition of the HCl after the $TiCl_4$ pulse significantly lowers the growth rate. For the high temperature range (>300°C), the additional HCl increased the growth rate. The authors postulated that at lower temperatures (150-300°C), the surface reaction occurs via OH-groups and forms intermediate or non-stable products, according to the reactions depicted on equations 1 and 2. HCl may induce the reversible reaction and promote the

desorption of $TiCl_{4-x}$ or $Ti(OH)_2Cl_2$ volatile compounds. The overall reaction being partially reversible, the growth rate of $TiO_2$ is lowered. Beyond 300°C, the oxygen bridge terminated surfaces are induced and promote the $TiCl_4$ adsorption as previously described without any release of HCl. The oxygen bridges are mainly triggering the $TiO_2$ growth reaction according to equation 4.

$$Ti(-O-)_2Ti + TiCl_4 \rightarrow Ti(Cl)-O-Ti(OTiCl_3)$$

$$(\text{equation 4})$$

This investigation highlights that the mono- (figure 5 Ia) or bifunctional (Figure 5 Ib) absorption of $TiCl_4$ on hydroxyl groups is reversible under HCl atmosphere, while dissociative absorption on oxygen bridges is irreversible. Interestingly, while HCl was added at the end of the ALD cycle (after water pulse), it significantly decreases the growth rate for the whole studied temperature range (150 - 400°C). When oxygen bridges are exposed to HCl (equation 5 and the schematic IIIb-IIIc represented on figure 5). $TiO_2$ surfaces are functionalised with -OH, -Cl, =OHCl. That retards the growth of $TiO_2$. This fundamental investigation highlights the predominant role of HCl on the $TiO_2$ growth mechanism. The time of residence of HCl in our ALD processes is strongly dependent on the purge time.

$$Ti(-O-)_2Ti + HCl \rightarrow Ti(Cl)-O-Ti(OH)$$

$$(\text{equation 5})$$

Therefore, further investigations require the optimisation of purge time using the quartz crystal microbalance (QCM). The QCM being integrated into the reactor lid cannot be used at deposition temperature above 250°C. Henceforth, the low temperature $TiO_2$ deposition regime was principally considered: at RT, 100 and 200°C, so more as these regimes conduct to the low surface roughness of $TiO_2$ films.

The importance of the purge time is logically more significant in the low temperature regime, where the excess of precursors and by-products desorption is not assisted by heat.

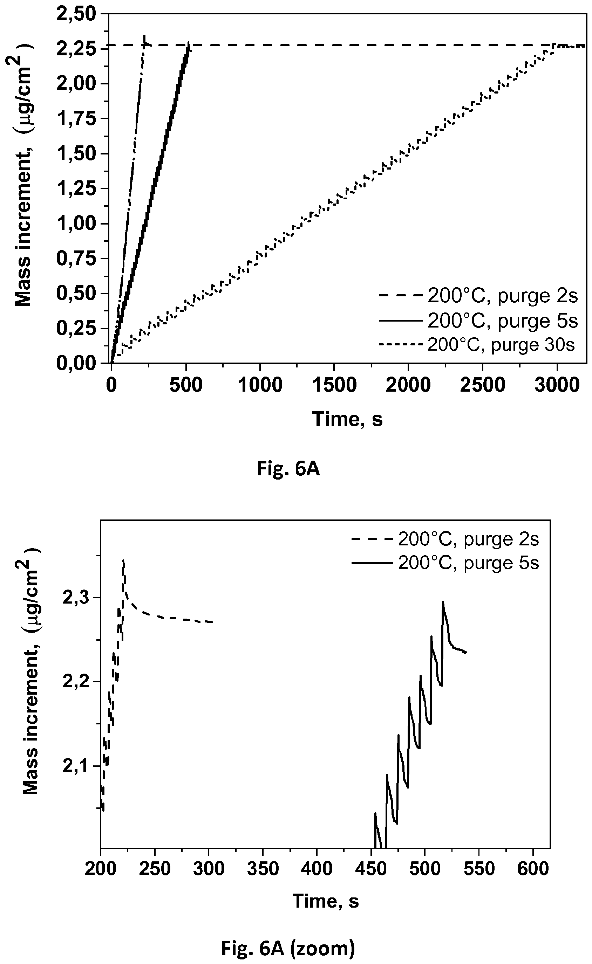

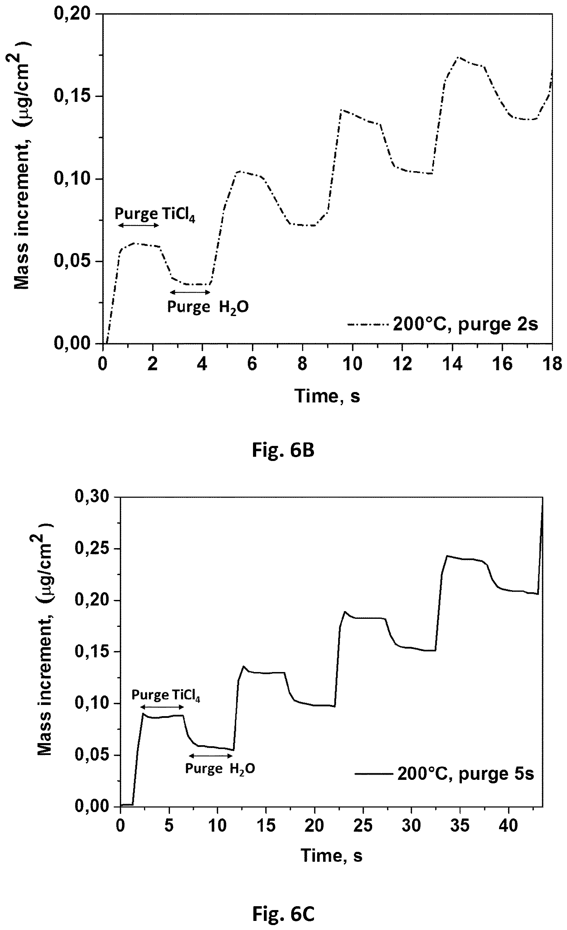

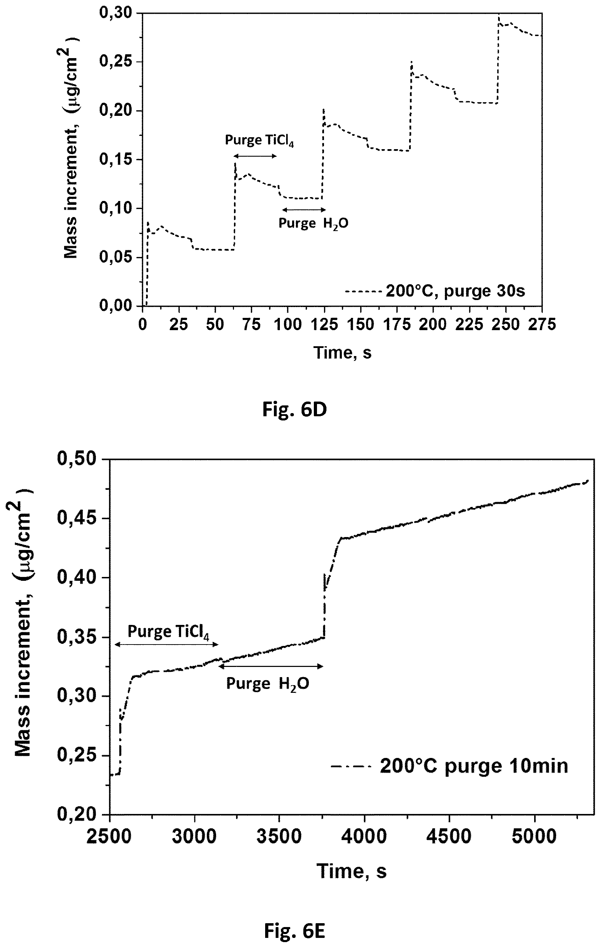

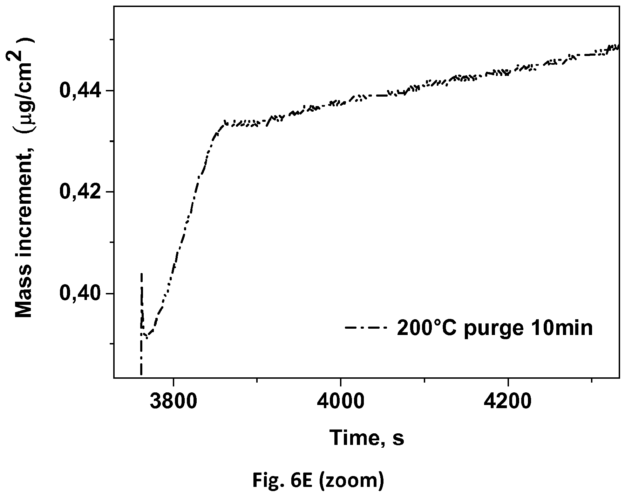

The QCM measurements realised first at 200°C using pulse time 0.2 s and purge time 2, 5, 30 s for both precursors (see figure 6). The pulse of $TiCl_4$ induces the mass increase following stabilisation during the purge.

The addition of a water pulse enables the surface reaction and the mass drop due to the release of HCl by-product (figure 6B). The completed mass stabilisation was not achieved in the case of a 2 s purge time.

The increase of the purge time up to 5 (figure 6C) and 30 s (figure 6D) improved the mass stabilisation. However, for a purge time of 30 s after the $TiCl_4$ pulse, an anomalous mass drop after 12-15 s of purge time is observed (figure 6D). To further study the "relaxation" time after the pulse of each precursor, an exaggerated purge of 600 s is applied (figure 6E).

This study shows that after the $TiCl_4$ pulse the mass signal decreases continuously during the first 5-8 s of purging, but then the mass re-increases significantly without any visible stabilisation. The water pulse promotes a slow mass decrease within the first 10 s of purging, then the sensor signal increases again.

Such QCM behaviour of mass increases within the long purge time is intriguing. It may be associated to the re-adsorption of volatile species or surface reaction by-products from the reactor walls and re-deposits on the QCM surface.

Moreover, after the completed 50 cycles deposition with purge time 2 and 5 s, the mass sensor signal continues to decrease; that could be characteristic of the desorption of volatile compounds (Figure 6 A zoom).

Aarik and co-workers (Aarik J. et al., ALD of TiO2 from TiCl4 and H2O: investigation of growth mechanism, Appl. Surf. Sci., 2001, 172, 148-158) also pointed out on the continuous decrease of mass sensor signal during the purge time for depositions realised at 100°C. The authors have suggested the continuous dehydration of the surface after exposure to water pulse at low temperature, or desorption/decomposition of formed $Ti(OH)_xCl_{4-x}$ volatile species.

The QCM control on the mass evolution during the ALD deposition demonstrated that, at 200°C, the purge time after the water injection should be longer than 600 s.

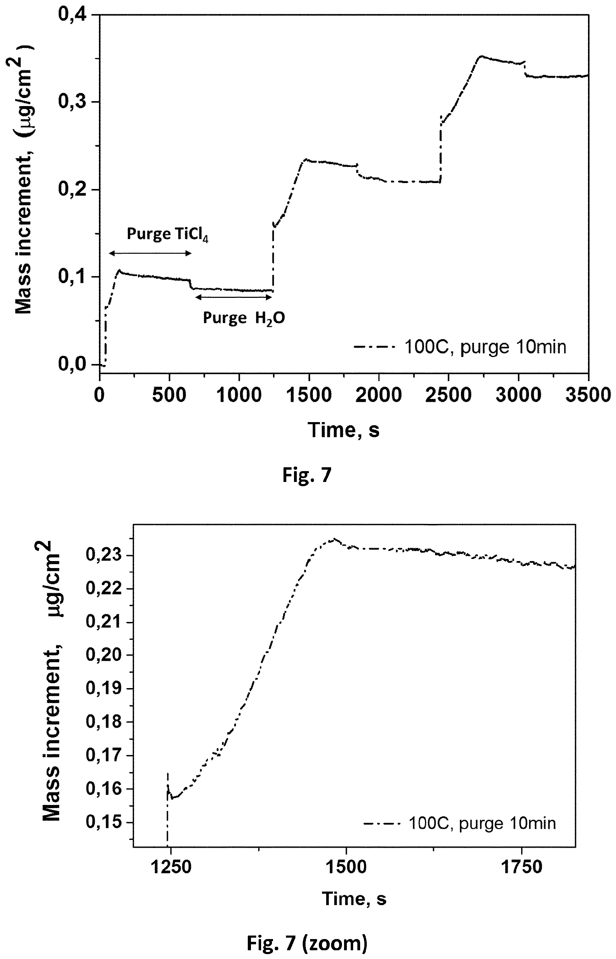

The decrease in the deposition temperature to 100°C does not significantly modify the mass sensor profiles compared to the previously recorded for 200°C. The study of the relaxation time at 100°C demonstrates that a purge time of 600s is still not sufficient to stabilise the mass sensor signal after the pulse of $TiCl_4$, however after injection of water, the mass sensor signal stabilisation is interestingly achieved after a purge time of 30 s of purge (see figure 7).

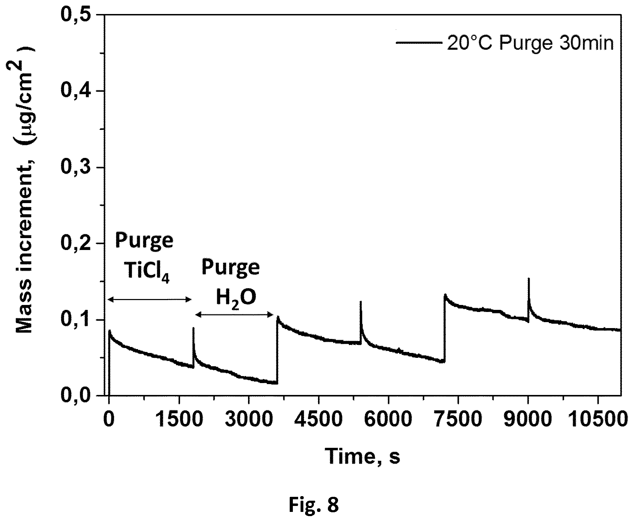

The mass change, as recorded by QCM, for depositions realised at room temperature is significantly different from previously discussed QCM profiles recorded for thin-films grown at 100 and 200°C. An anomalous behaviour is noted while the water pulse is supplied. Instead of the mass decrease due to the HCl release, the mass sensor shows a mass increase and then a continuous decrease of the mass increment without stabilisation, even after 30 min of purge (figure 8).

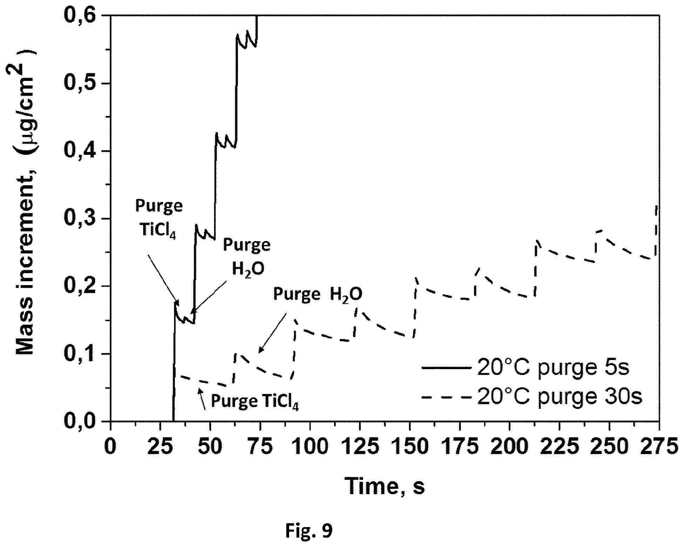

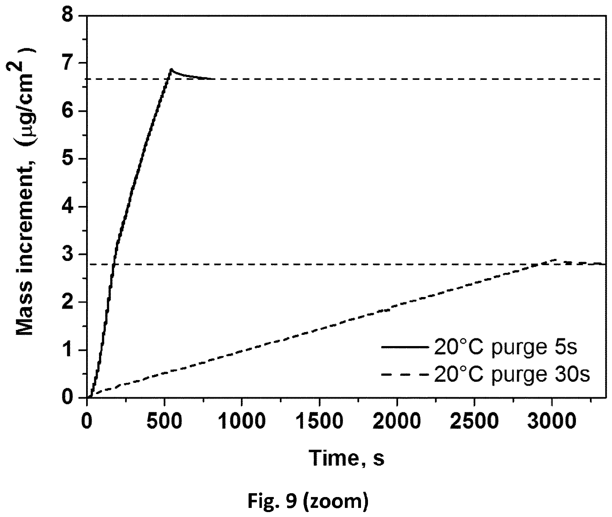

The mass increment per cycle is strongly dependent on the purge time. The mass increments per cycle of ~ 0.14, 0.06, and 0.02 $\mu$g/cm$^2$ is determined for depositions realised with 5, 30 and 1800 s purge time. The final mass increment, after 50 cycles, is twice larger for 5 s purge time than for 30 s purge time (see figure 9) at room temperature.

For high temperature (100 and 200°C), the final mass increment is not significantly different for the different purge time. This demonstrates that the unreacted precursors or by-product thus accumulate within the film at room temperature. At a low temperature, the surface is mainly functionalised by hydroxyl groups and H-bonded OH. Furthermore at temperatures below 100°C, the presence of molecularly absorbed water on the surface is inevitable. Thus, $TiCl_4$ molecules could react not only with functional groups but also with residual water. The reaction of $TiCl_4$ hydrolysis at room temperature generally leads to the formation of $TiOCl_2$, TiOCl, $Ti_2O_3$ and/or $Ti(OH)_xCl_{4-x}$ with generation of HCl. All of these chemistries may be expected in the films.

Several theoretical studies have reported that the first half-reaction of $TiCl_4$ and $H_2O$ is endothermic and thus the desorption of HCl is hampered. That is in line with our hypothesis about an accumulative growth mechanism at room temperature.

Nevertheless, it is important to consider the slow film growth rate (~6 Å/ cycle for purge 30 s) for which a further increase in the purge time (to reach the ideal ALD regime) will lead to an unreasonably long deposition time (dozens of hours), for the considered $TiO_2$ thickness.

Consequently, $TiO_2$ thin-films deposited with purge times of 5 s and 30 s were chosen and since ALD thin films grown at low temperature are amorphous, the post-deposition annealing for engineering the thin film crystallisation was used. The use of anodized aluminium oxide (AAO) membranes for further $TiO_2$ nanowires fabrication also imposes the annealing temperature limit at 600°C.

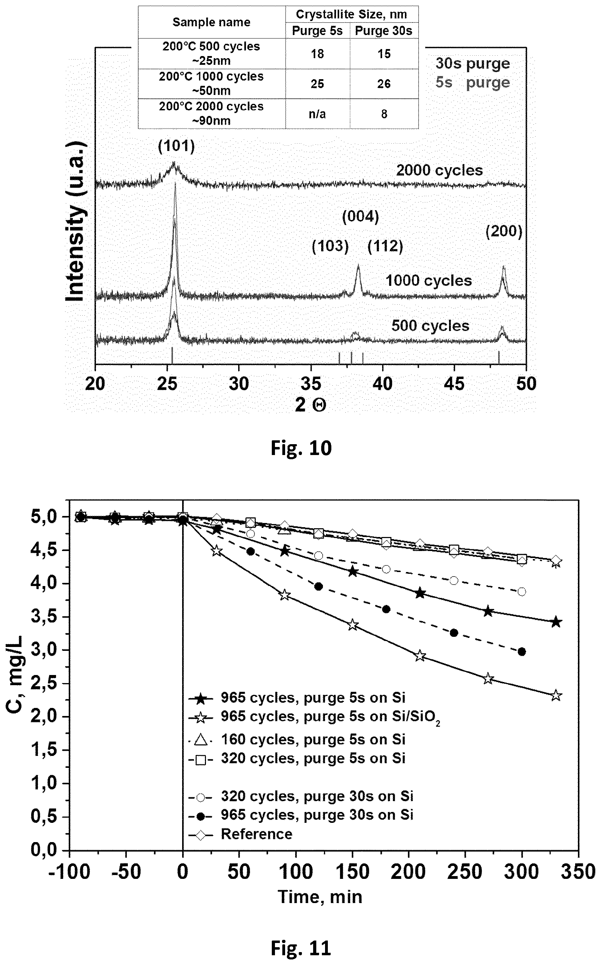

The used ALD pulse/purge parameters are 0.2 s pulse / 5 s and 30 s nitrogen purge for both precursors and result in different thicknesses of 25, 50, 90 nm corresponding to 500, 1000, 2000 cycles. The $TiO_2$ films grown with the purge time 30s are much less crystallised than the films grown with 5 s purge time (figure 10).

The ALD process is thus carried out at a temperature inferior to 50°C, preferentially at a temperature comprised between 20°C (room temperature) and 50°C.

The photocatalytic activity of the room temperature-deposited $TiO_2$ films with various thickness and grown with both purge time is tested under the visible range irradiation. The obtained degradation curves on methylene blue, presented on figure 11, confirm the activity of the films in the visible range whatever the used growth process, substrate and thickness.

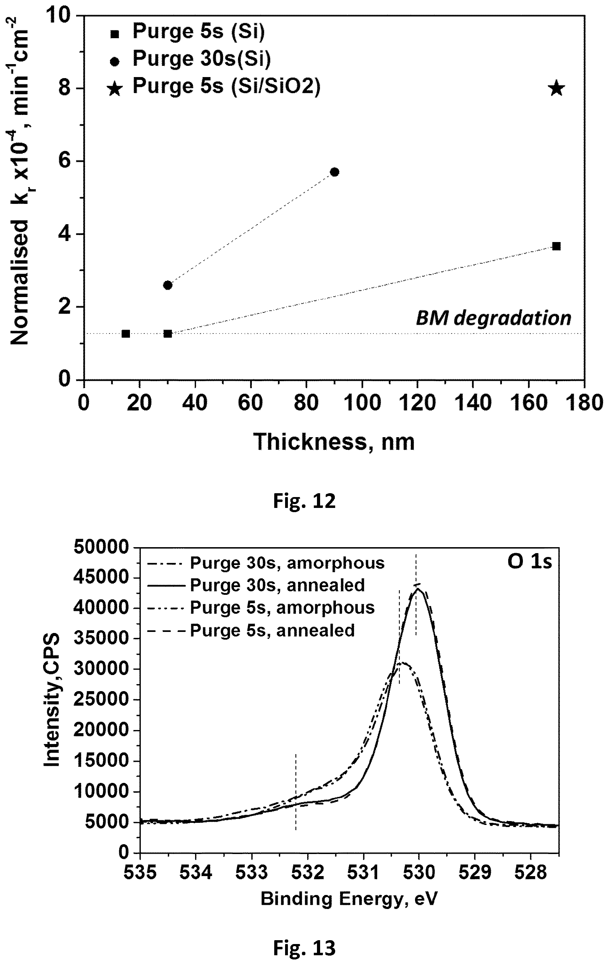

The best performing mesoporous thin film is grown on thermally oxidised Si substrates. The photocatalytic degradation is enhanced with the film thickness, with a degradation rate constant reaching 57.6•10$^{-4}$ for the 170 nm thick film grown with 5 s purge time. In the visible range, the photocatalytic degradation constant normalised by the sample surface area versus film thickness is higher in the case of films deposited on Si with a 30 s purge time (figure 12). For the short purge time (5 s), thin films lower than 30 nm are not active in the visible range when grown on the Si substrate. Only thicker film (170 nm) shows degradation when the 5 s purge time process is used to elaborate the mesoporous $TiO_2$. However, the deposition of a thick film of 170 nm on the oxidised substrate (Si/SiO$_2$) with 5 s purge time shows the maximum photocatalytic degradation values at 8.0•10$^{-4}$ min$^{-1}$cm$^{-2}$.

The interplay between physical and chemical properties of room temperature ALD $TiO_2$ films and their photocatalytic performance in both UV and visible ranges is discussed hereafter.

The use of the room temperature process condition significantly modifies the $TiO_2$ thin film chemistry and morphology. First of all, an amorphous thin-film of $Ti_xO_y$ is grown and traps unreacted precursors, reaction by-products, and complex $Ti-O_x-H_y-Cl_z$ chemistries typically characterised as-grown thin films.

Then, the post-deposition annealing of the amorphous films enables the thermal oxidation of the film under ambient air conditions, promotes degassing of the chlorine compounds and leads to a mesoporous hydrogenated-$Ti_xO_y$ thin film.

The degassing of a chlorine compound (typically HCl or $Cl_2$) may induce oxygen vacancies in the film volume and $Ti^{3+}$. The chemical characterisation of the films before and after annealing by the XPS analysis does not show any change in the Ti 2p spectra. O 1s peak is systematically shifted towards high binding energy (+0.3 eV) when amorphous films are annealed (see figure 13). O 1s shoulder at 532 eV is attributed to the hydroxylation of $TiO_2$ (Ti-OH) (see Chen X. et al., Increasing solar absorption for photocatalysis with black hydrogenated TiO2 nanocrystals, Sciences, 2011, 331 (6018), 746-750).

Chen *et al.* noted two O 1s peak contributions at 530 to 530.9 eV without Ti 2p spectral modification. The authors postulated that hydroxylation of $TiO_2$ by hydrogen treatment induces a significant disorder of the crystalline structure *i.e.* oxygen vacancies, hydroxylation of the dangling bonds and Ti-OH.

These structural defects may have a significant impact on the electronic properties via inter bang gap energetic levels. The theoretical predictions realised by Chen *et al.* predicts that disordered hydrogenated-$TiO_2$ crystals induce

mid-gap electronic states at 1.8 eV and high-energy states at 3 eV, leading to a band gap narrowing.

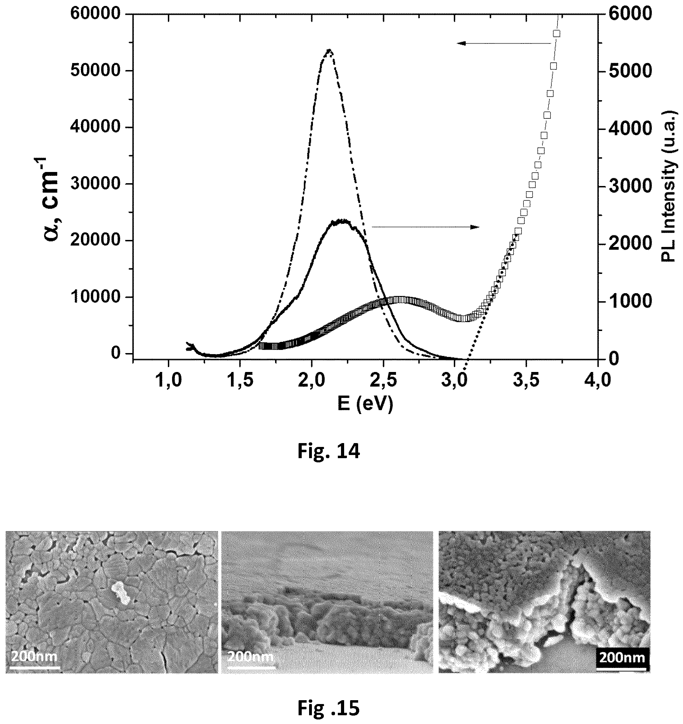

In the present case, photoluminescence (PL) profiles (see figure 14) evidence defects contributing to the radiative recombination of carriers at ~500-525 nm (2.48-2.36 eV), -585nm (2.11 eV) and ~700nm (1.77 eV).

The room temperature $TiO_2$ samples (965 cycles, 5s) deposited on quartz substrates are characterized by UV-Vis spectroscopy. The optical band gap remains close to usual $TiO_2$ values (-3.1 eV) however an additional absorption band is noted between 2 and 3 eV (413-620 nm). This corresponds to the light absorption in the visible range. PL peaks are also reported for comparison and evidences a lower radiative energy of excitons than the peak energy of the visible absorption. The atypical stoichiometry and morphology of room temperature thin-films induces multiple energy levels within the $TiO_2$ band gap.

From these first results, it was suggested that room temperature thin-films feature specific oxygen vacancies and Ti-OH coordination. Room temperature ALD process thus leads to HCl or $Ti-O_x-H_y-Cl_z$ in amorphous films.

During annealing, the HCl degasing promotes oxygen vacancies and $Ti^{3+}$ while its thermals decomposition at 600°C into $Cl_2$ and $H_2$ leads to *"in-situ"* hydrogen treatment of $TiO_2$.

Hydrogenation process has been shown recently to modify significantly the opto-electronic properties of $TiO_2$ due to a significant concentration of Ti-OH inducing disordered crystalline arrangement. Such features are shown to modify considerably the photocatalytic responses (see Park S.K et al., Effect of HCl and H2SO4 treatment of TiO2 powder on the photosensitized degradation of aqueous rhodamine B under visible light, J. Nanosci. Nanotechnol., 2014, 14(10), 8122-8128).

In the present case, the astonishing photocatalytic efficiency is also correlated to the immense specific area (see optical images on figure 15) and the *"in-situ"* hydrogenation of $TiO_2$.

The samples having a very high surface area, the lack of simple adsorption of methylene blue (*i.e.,* without any degradation) within the sample should be checked. To this end the photocatalytic degradation is repeated 4 times on the same sample. Moreover, for one of the runs, the sample is held overnight in the methylene blue solution. In that case, the change in the methylene blue concentration is almost insignificant. The photocatalytic degradation rate is unchanged even after 4 runs, highlighting the very high stability and efficacy of the samples that show unchanged photocatalytic performance over time.

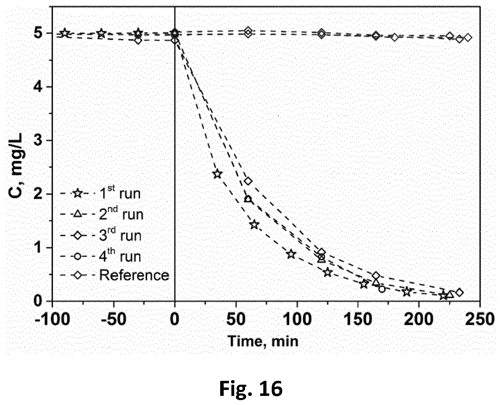

After four hours, methylene blue, an acidic molecule, is fully degraded, regardless of the number of experiments performed with the same sample. This remarkable photocatalytic efficiency competes with the very best material solution provided today (see figure 16).

The methylene blue affinity to the $TiO_2$ surface facilitates its degradation. An efficient photocatalytic system shall degrade multiple molecule chemistries. Therefore, the mesoporous $TiO_2$ is also exposed to other target molecules such as rhodamine B (a basic molecule) and salicylic acid (a neutral molecule) at the same time as methylene blue.

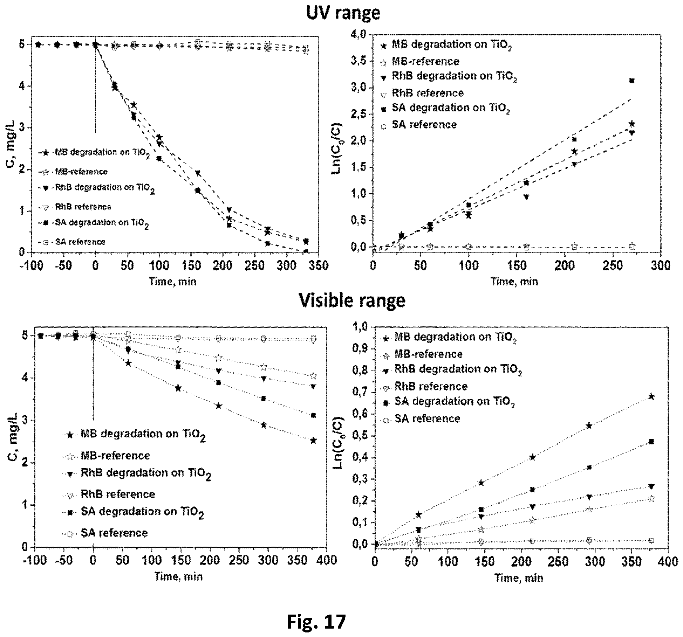

Those photocatalytic tests are performed using methylene blue, rhodamine B, and salicylic acid solutions with an equivalent concentration of 5 mg/L under UV and visible irradiation (see figure 17). The molar concentration for methylene blue, rhodamine B, and salicylic acid corresponds to 15, 10 and 36 $\mu$mol/L, respectively. The degradation rate in the UV range, namely with a light with a wavelength comprised between 1 nm and 400 nm, is almost identical for the three target molecules.

Table 2 indicates the photocatalytic degradation constants on room temperature $TiO_2$ normalized by the sample surface area (min$^{-1}$ cm$^{-2}$), and photolysis constants of the reference solutions.

| Target molecule | Kr, normalised by the sample surface area, min$^{-1}$cm$^{-2}$ | | | |
| --- | --- | --- | --- | --- |
| | UV range | | Visible range | |
| | On $TiO_2$ | Reference | On $TiO_2$ | Reference |
| methylene blue | $3.8 \cdot 10^{-3}$ | $9 \cdot 10^{-5}$ | $0.8 \cdot 10^{-3}$ | $5.8 \cdot 10^{-5}$ |
| rhodamine B | $3.1 \cdot 10^{-3}$ | $4 \cdot 10^{-5}$ | $0.3 \cdot 10^{-3}$ | $4.3 \cdot 10^{-5}$ |
| salicylic acid | $5 \cdot 10^{-3}$ | $4 \cdot 10^{-5}$ | $0.6 \cdot 10^{-3}$ | $5 \cdot 10^{-5}$ |

In the present case, the photocatalytic degradation under UV light is not dependent on the molecular affinity towards of the photocatalyst surface. This feature is of very high interest for depolluting water typically characterised by a mixture of pollutant molecules having significantly different chemical features such as steric volume, polarity, and chemical termination.

Water can be sea water, river water, wastewater and/or industrial water.

The photocatalyst can also be used in a water splitting process, a photolysis process and/or a hydrogen generation process.

For instance, when considering emerging photocatalysts such as the $Bi_2WO_6$ nanosheet with a positively charged surface, the methylene blue and rhodamine B were found to have higher adsorption, while neutrally-charged molecule like salicylic acid are hardly adsorbed (and thus degraded) on such a surface (see Zhou Y. et al., Monolayered Bi2WO6 nanosheets mimicking heterojunction interface with open surfaces for photocatalysis, Nat. Comm., 2015, 6, 8340).

In the present case, a slight increase in the degradation constant on salicylic acid is measured when compared to the two other molecules.

When visible light irradiation is used, namely a light with a wavelength comprised between 400 nm and 780 nm, the degradation rate for the same tested pollutants is different. The degradation constant of methylene blue is the highest, but the "natural" degradation of methylene blue under visible light must be considered, as evidenced by the significant photodegradation of the reference solution. The salicylic acid and rhodamine B molecules are highly stable under visible light, as proven by the concentration plateau of the reference solution. The photocatalytic degradation under visible light is even more efficient for neutral molecules such as salicylic acid compared to methylene blue and rhodamine B, showing that the mesoporous $TiO_2$ material is particularly efficient. The photocatalytic degradation rate for different molecules was formerly explained by better adsorption due to the charge difference between the surface and the molecule.

However, those results in the UV range contradict this assumption, showing an identical degradation rate for all molecules. The lower activity in the visible range may be due to the lower carrier density and thus lower radical concentration. Therefore, in the visible range, the degradation occurs according to the stability of the molecules.

**Claims**

1. Process for depositing $TiO_2$ on a substrate, comprising the following steps:

   a) providing a substrate;
   b) performing said deposition with $TiCl_4$ and water by atomic layer deposition on said substrate; and
   c) performing an annealing step;

   wherein step (b) is carried out at a temperature inferior to 50°C, preferentially at a temperature comprised between 20°C and 50°C, and wherein step (c) is carried out at a temperature comprised between 450°C and 600°C in ambient air.

2. Process according to claim 1, wherein said substrate is curved glass.

3. Process according to claim 1 and/or claim 2, wherein said substrate is porous.

4. Process according to any one of claims 1-3, wherein said substrate is a silicon substrate with a layer of silicon oxide.

5. Process according to any one of claims 1-4, wherein said step (b) comprises pulsing $TiCl_4$ on said substrate so as to form a functionalized substrate, purging with an inert gas, pulsing $H_2O$ on said functionalized substrate, and purging with an inert gas, said inert gas being preferentially nitrogen gas.

6. Process according to claim 5, wherein said purging with an inert gas lasts between 5 seconds and 30 seconds.

7. Process according to any one of claims 1-6 wherein step (c) is carried out for at least 2 hours.

8. Process according to any one of claims 1-7, wherein step (b) is performed between 100 times and 1000 times.

9. Photocatalyst comprising at least one layer of mesoporous hydrogenated $TiO_2$ on a substrate and obtainable by the process in accordance with any one of claims 1-8, wherein said at least one layer of mesoporous hydrogenated $TiO_2$ has a thickness which is comprised between 30 nm and 170 nm, **characterized in that** said at least one layer is presenting a roughness, RMS value, as measured by AFM, of 0.77 nm at room temperature.

10. Use of a photocatalyst as defined in accordance with claim 9, in a photocatalytic reaction of chemical degradation of a mixture of methylene blue, rhodamine B and/or salicylic acid, performed under light irradiation, said light having a wavelength comprised between 1 nm and 780 nm.

**11.** Use of a photocatalyst as defined in accordance with claim 9, in a photocatalytic reaction performed in a water splitting process, a photolysis process and/or a hydrogen generation process.

**12.** Use according to claim 11, in a photocatalytic reaction performed in water, wastewater, see water, river water, and/or industrial water.

**Patentansprüche**

**1.** Ein Verfahren zum Abscheiden von $TiO_2$ auf einem Substrat, das die folgenden Schritte umfaßt:

a) Bereitstellen eines Substrats;
b) Durchführen der Abscheidung mit $TiCl_4$ und Wasser durch Atomschichtabscheidung auf dem Substrat; und
c) Durchführen eines Glühschritts;

wobei Schritt (b) bei einer Temperatur unter 50°C, vorzugsweise bei einer Temperatur zwischen 20°C und 50°C, durchgeführt wird, und wobei Schritt (c) bei einer Temperatur zwischen 450°C und 600°C in Umgebungsluft durchgeführt wird.

**2.** Verfahren nach Anspruch 1, wobei das Substrat gebogenes Glas ist.

**3.** Verfahren nach Anspruch 1 und/oder Anspruch 2, wobei das Substrat porös ist.

**4.** Verfahren nach einem der Ansprüche 1 bis 3, wobei das Substrat ein Siliziumsubstrat mit einer Schicht aus Siliziumoxid ist.

**5.** Verfahren nach einem der Ansprüche 1-4, wobei der Schritt (b) das Aufbringen von $TiCl_4$ auf das Substrat, um ein funktionalisiertes Substrat zu bilden, das Spülen mit einem Inertgas, das Aufbringen von $H_2O$ auf das funktionalisierte Substrat und das Spülen mit einem Inertgas umfasst, wobei das Inertgas vorzugsweise Stickstoffgas ist.

**6.** Verfahren nach Anspruch 5, wobei die Spülung mit einem Inertgas zwischen 5 Sekunden und 30 Sekunden dauert.

**7.** Verfahren nach einem der Ansprüche 1-6, wobei Schritt (c) mindestens 2 Stunden lang durchgeführt wird.

**8.** Verfahren nach einem der Ansprüche 1-7, wobei Schritt (b) zwischen 100 Mal und 1000 Mal durchgeführt wird.

**9.** Ein Photokatalysator, der mindestens eine Schicht aus mesoporösem hydriertem $TiO_2$ auf einem Substrat umfasst und durch das Verfahren nach einem der Ansprüche 1-8 erhältlich ist, wobei die mindestens eine Schicht aus mesoporösem hydriertem $TiO_2$ eine Dicke zwischen 30 nm und 170 nm aufweist, **dadurch gekennzeichnet, dass** die mindestens eine Schicht eine Rauheit, RMS-Wert, gemessen mit AFM, von 0,77 nm bei Raumtemperatur aufweist.

**10.** Verwendung eines Photokatalysators gemäß Anspruch 9 in einer photokatalytischen Reaktion des chemischen Abbaus einer Mischung aus Methylenblau, Rhodamin B und/oder Salicylsäure, die unter Lichtbestrahlung durchgeführt wird, wobei das Licht eine Wellenlänge zwischen 1 nm und 780 nm aufweist.

**11.** Verwendung eines Photokatalysators gemäß Anspruch 9 in einer photokatalytischen Reaktion, die in einem Wasserspaltungsprozess, einem Photolyseprozess und/oder einem Wasserstofferzeugungsprozess durchgeführt wird.

**12.** Verwendung nach Anspruch 11 in einer photokatalytischen Reaktion, die in Wasser, Abwasser, Meerwasser, Flusswasser und/oder Industriewasser durchgeführt wird.

**Revendications**

**1.** Procédé permettant de déposer une couche de $TiO_2$ sur un substrat, comprenant les étapes consistant à :

a) fournir un substrat ;

b) exécuter ledit dépôt avec du TiCl$_4$ et de l'eau par dépôt en couche atomique sur ledit substrat ; et

c) exécuter une étape de recuit ;

dans lequel l'étape (b) est effectuée à une température inférieure à 50°C, de préférence à une température comprise entre 20°C et 50°C, et dans lequel l'étape (c) est effectuée à une température comprise entre 450°C et 600°C dans l'air ambiant.

2. Procédé selon la revendication 1, dans lequel ledit substrat est du verre bombé.

3. Procédé selon la revendication 1 et/ou la revendication 2, dans lequel ledit substrat est poreux.

4. Procédé selon l'une quelconque des revendications 1 à 3, dans lequel ledit substrat est un substrat de silicium avec une couche d'oxyde de silicium.

5. Procédé selon l'une quelconque des revendications 1 à 4, dans lequel ladite étape (b) consiste à pulser du TiCl$_4$ sur ledit substrat de manière à former un substrat fonctionnalisé, à purger avec un gaz inerte, à pulser du H$_2$O sur ledit substrat fonctionnalisé et à purger avec un gaz inerte, ledit gaz inerte étant de préférence de l'azote gazeux.

6. Procédé selon la revendication 5, dans lequel l'étape consistant à purger avec un gaz inerte dure entre 5 et 30 secondes.

7. Procédé selon l'une quelconque des revendications 1 à 6, dans lequel l'étape (c) est effectuée pendant au moins 2 heures.

8. Procédé selon l'une quelconque des revendications 1 à 7, dans lequel l'étape (b) est exécutée entre 100 et 1000 fois.

9. Photocatalyseur comprenant au moins une couche de TiO$_2$ hydrogéné mésoporeux sur un substrat et pouvant être obtenu à l'aide du procédé selon l'une quelconque des revendications 1 à 8, dans lequel ladite au moins une couche de TiO$_2$ hydrogéné mésoporeux a une épaisseur comprise entre 30 nm et 170 nm, **caractérisé en ce que** ladite au moins une couche présente une rugosité, valeur RMS, telle que mesurée par AFM, de 0,77 nm à température ambiante.

10. Utilisation d'un photocatalyseur tel que défini selon la revendication 9, dans une réaction photocatalytique de dégradation chimique d'un mélange de bleu de méthylène, de rhodamine B et/ou d'acide salicylique, effectuée sous irradiation lumineuse, ladite lumière ayant une longueur d'onde comprise entre 1 nm et 780 nm.

11. Utilisation d'un photocatalyseur tel que défini selon la revendication 9, dans une réaction photocatalytique effectuée dans un processus de séparation de l'eau, un processus de photolyse et/ou un processus de production d'hydrogène.

12. Utilisation selon la revendication 11, dans une réaction photocatalytique effectuée dans l'eau, les eaux usées, l'eau de mer, l'eau de rivière et/ou l'eau industrielle.

**Fig. 1**

**Fig. 2**

**Fig. 3**

**Fig. 4**

**Fig. 5**

Fig. 6A

Fig. 6A (zoom)

**Fig. 6B**

**Fig. 6C**

**Fig. 6D**

**Fig. 6E**

Fig. 6E (zoom)

Fig. 7

Fig. 7 (zoom)

Fig. 8

**Fig. 9**

Fig. 9 (zoom)

| Sample name | Crystallite Size, nm | |
| --- | --- | --- |
| | Purge 5s | Purge 30s |
| 200°C 500 cycles ~25nm | 18 | 15 |
| 200°C 1000 cycles ~50nm | 25 | 26 |
| 200°C 2000 cycles ~90nm | n/a | 8 |

**Fig. 10**

**Fig. 11**

Fig. 12

Fig. 13

**Fig. 14**

**Fig .15**

**Fig. 16**

**Fig. 17**

## REFERENCES CITED IN THE DESCRIPTION

**Patent documents cited in the description**

- CN 103611518 A

- WO 03092886 A1

**Non-patent literature cited in the description**

- **CHENG H.-E. et al.** Morphological and Photoelectrochemical properties of ALD TiO2 films. *J. Electrochem. Soc.,* 2008, vol. 155 (9), D604
- **AARIK J. et al.** Morphology and structure of TiO2 thin film grown by ALD. *J. Cryst. Growth,* 1995, vol. 148 (3), 268-275
- **TAN L. K. et al.** *Free-Standing Porous Anodic Alumina Templates for ALD of Highly Ordered TiO2 Nanotube Arrays an Various Substrate,* 2008, vol. 112 (1), 69-73
- **MOZIA S.** Photocatalytic membrane reactors (PMRs) in water and wastewater treatment. *Sep. Purif. Technol.,* 2010, vol. 73 (2), 71-91
- **TSYDENOV D.E. et al.** Toward the design of asymmetric photocatalytic membranes for H2 production: preparation of TiO2-based membranes and their properties. *Int. J. Hydrogen Energy,* 2012, vol. 37 (15), 11046-11060
- Characteristics of atomic layer deposited TiO2 films and their photocatalytic activity. **PHEAMHOM ROD-JANA et al.** JOURNAL OF VACUUM SCIENCE AND TECHNOLOGY: PART A. AVS /AIP, 23 June 2006, vol. 24, 1535-1539
- **HUANG. Y et al.** Characterization of low temperature deposited ALD TiO2 for MEMS application. *J. Vac. Sci. Technol. A Vacuum, Surfaces, Films,* 2012, vol. 31, 01A148
- **LUKA et al.** Kinetics of anatase phase formation in TiO2 films during ALD and post-deposition annealing. *CrystEngComm,* 2013, vol. 15 (46), 9949
- **AARIK J. et al.** ALD of TiO2 from TiCl4 and H2O: investigation of growth mechanism. *Appl. Surf. Sci.,* 2001, vol. 172, 148-158
- **LEEM et al.** *Role of HCl in ALD of TiO2 thin films from TiCl4 and water,* 2014, vol. 35 (4), 1195-1201
- **CHEN X. et al.** Increasing solar absorption for photocatalysis with black hydrogenated TiO2 nanocrystals. *Sciences,* 2011, vol. 331 (6018), 746-750
- **PARK S.K et al.** Effect of HCl and H2SO4 treatment of TiO2 powder on the photosensitized degradation of aqueous rhodamine B under visible light. *J. Nanosci. Nanotechnol.,* 2014, vol. 14 (10), 8122-8128
- **ZHOU Y. et al.** Monolayered Bi2WO6 nanosheets mimicking heterojunction interface with open surfaces for photocatalysis. *Nat. Comm.,* 2015, vol. 6, 8340